# EUROPÄISCHE PATENTANMELDUNG

(11) **EP 1 942 560 A1**
(43) Veröffentlichungstag der Anmeldung: **09.07.2008**
(21) Anmeldenummer: 07005720.3
(22) Anmeldetag: 20.03.2007
(51) Int. Cl.: H01R 13/658

(54) **Industrietauglicher Steckverbinder**

(71) Anmelder: SIEMENS AKTIENGESELLSCHAFT, 80333 München (DE)
(72) Erfinder: Die Erfindernennung liegt noch nicht vor

(57) **Zusammenfassung**

Die Erfindung betrifft einen Steckverbinder zur Montage auf einer Leiterplatte (3), mit einem elektromagnetisch schirmenden Gehäuse (1). Um das Aussenden und die Einkopplung elektromagnetischer Störungen an der Schnittstelle zwischen dem Steckverbinder und der Leiterplatte (3) möglichst gering zu gestalten, wird vorgeschlagen, dass der Steckverbinder Signalanschlüsse zur Verbindung von Signalleitungen mit Signalanschlusspunkten der Leiterplatte (3) umfasst und das Gehäuse (1) eine Schirmanbindung (4,5) zur Verbindung des Gehäuses mit einem Schirmanschluss (6) auf der Leiterplatte aufweist, wobei die Schirmanbindung (4,5) zur elektrischen Kontaktierung mit dem Schirmanschluss (6) mittels einer Lötverbindung an mindestens vier Punkten ausgebildet ist, die derart angeordnet sind, dass sie zu einem geschlossenen, die Signalanschlusspunkte (2) der Leiterplatte (3) umschließenden Polygonzug verbindbar sind.

## Beschreibung

Die Erfindung betrifft einen Steckverbinder mit den Merkmalen gemäß Oberbegriff des Patentanspruchs 1.

Aus Gründen der elektromagnetischen Verträglichkeit werden insbesondere im industriellen Umfeld geschirmte Steckverbinder verwendet, die direkt auf eine Leiterplatte gelötet werden. Der Begriff Steckverbinder bezeichnet im gesamten Dokument einen für eine Steckverbindung geeigneten Stecker oder eine hierfür geeignete Buchse.

Die Schirmung dieser Steckverbinder wird durch ein elektrisch leitfähiges Gehäuse realisiert, welches in der Regel aus Metall besteht. Bei der Montage eines Steckverbinders müssen neben den Signalleitungen auch eine Schirmanbindung vorgesehen werden, über die das Gehäuse mit einem Schirmanschluss der Leiterplatte kontaktiert wird. Derartige Schirmanschlüsse dienen der Weiterleitung eines Kabelschirms, welches mit dem Steckverbinder verbunden ist, zur Leiterplatte. Auf der Leiterplatte erfolgt schließlich eine Weiterführung des Schirms zu einer zentralen Schirmableitung. Hierbei kann es sich beispielsweise um einen metallischen Baugruppenträger, ein Gehäuse oder einen Funktions- oder Schutzerdeanschluss handeln.

Die Kabelschirme werden insbesondere bei Kommunikationssystemen mit sehr schnellen Signalen zum Schutz vor elektromagnetisch eingekoppelten Störungen vorgesehen. Darüber hinaus verhindern die Kabelschirme, dass Störungen vom entsprechenden Kabel selbst ausgesendet werden.

Eine zuverlässige Auslegung des gesamten Schirmungssystems ist insbesondere bei einer industriellen echtzeitfähigen Kommunikation besonders wichtig. Hierbei können in die Signalleitungen eingekoppelte Störungen verheerende Auswirkungen haben.

Über das gesamte Schirmungssystem werden Störströme abgeleitet. Bedingt durch diese Störströme werden in der Umgebung des Schirmsystems Magnetfelder generiert. Ist das Schirmsystem nicht ideal in sich geschlossen ausgeführt, können diese Magnetfelder in den Signalleitungen oder auch in anderen auf der Leiterplatte oder daneben befindlichen Komponenten Störspannungen hervorrufen, die das elektrische System erheblich in seiner Funktion beeinträchtigen können. Kritisch hierbei sind vor allem Schnittstellen, an denen in der Regel Steckverbinder bestehend aus Buchsen und Stecker zum Einsatz kommen. Hier sind eine besonders sorgfältige Schirmverbindung und deren EMV-mäßig optimale Gestaltung wichtig. Dabei stellen insbesondere die Anschlüsse der Steckverbinder, d.h. der Übergang vom Steckverbinder zur Leiterplatte, erhebliche Schwachpunkte dar.

Der Erfindung liegt die Aufgabe zugrunde, das Aussenden und die Einkopplung elektromagnetischer Störungen an der Schnittstelle zwischen einem Steckverbinder und einer Leiterplatte, auf der der Steckverbinder montiert werden soll, möglichst gering zu gestalten.

Diese Aufgabe wird durch einen Steckverbinder zur Montage auf einer Leiterplatte gelöst, wobei der Steckverbinder ein schirmendes, elektrisch leitfähiges Gehäuse und Signalanschlüsse zur Verbindung von Signalleitungen mit Signalanschlusspunkten der Leiterplatte umfasst und das Gehäuse eine Schirmanbindung zur Verbindung des Gehäuses mit einem Schirmanschluss auf der Leiterplatte aufweist, wobei die Schirmanbindung zur elektrischen Kontaktierung mit dem Schirmanschluss mittels einer Lötverbindung an mindestens vier Punkten ausgebildet ist, die derart angeordnet sind, dass sie zu einem geschlossenen, die Signalanschlusspunkte der Leiterplatte umschließenden Polygonzug verbindbar sind.

Bei der Erfindung geht es um eine optimale Gestaltung des Übergangs vom Steckverbinder zur Trägerplatte. An den vier Punkten besteht durch die Lötverbindung eine niederimpedante Verbindung zwischen der Schirmanbindung des Steckverbinders und des Schirmanschlusses der Leiterplatte. Verbindet man diese vier Punkte mit einem Linienzug, so entsteht eine durch diesen Linienzug begrenzte Fläche, auf der die Signalanschlusspunkte der Leiterplatte angeordnet sind. Eine derartige Anordnung ist aus EMV Sicht sehr günstig, da sich hierdurch auch eine schirmende Wirkung an der Schnittstelle zwischen den Signalanschlüssen des Steckverbinders und den Signalanschlusspunkten des Gehäuses ergibt.

Diese schirmende Wirkung ist in vorteilhafter Ausgestaltung der Erfindung dann besonders effektiv, wenn die Punkte derart angeordnet sind, dass sich magnetische Felder, die von einem über die Schirmanbindung zum Schirmanschluss fließenden Störstrom ausgehen, innerhalb der vom Polygonzug umschlossenen Fläche weitgehend kompensieren. Im einfachsten Fall definieren genau vier Punkte der Schirmanbindung den Umriss eines Rechtecks, wobei sich die Signalanschlüsse bei verbundenem Steckverbinder innerhalb dieses Rechtecks befinden. Innerhalb der durch die vier Punkte definierten Ecken des Rechtecks sind benachbarte Magnetfelder immer gegeneinander gerichtet, so dass sie sich im Inneren der vier Ecken gegenseitig aufheben und somit keine Störungen der ebenfalls im Inneren geführten Signale verursachen. Hierdurch resultiert eine erhebliche Verbesserung der Störfestigkeit. Durch die Signale hervorgerufenen Störungen sind wenigstens von den vier Schirmverbindungen umgeben, so dass eine Störaussendung erschwert wird.

Die schirmende Wirkung an der Schnittstelle zwischen Steckverbinder und Leiterplatte kann in weiterer vorteilhafter Ausgestaltung der Erfindung noch weiter optimiert werden, wenn die Schirmanbindung zur elektrischen Kontaktierung mit dem Schirmanschluss mittels einer sich über den Polygonzug zumindest abschnittsweise erstreckenden, linear verlaufenden Lötverbindung ausgebildet ist.

Hierbei kann im Idealfall die gesamte umlaufende Grundfläche des Steckverbinders mit dem Schirmpotential der Leiterplatte verbunden werden. Unter der Grundfläche wird die Fläche des Steckverbinders verstanden, die im montierten Zustand der Leiterplatte zugewandt ist. Die Signalleitungen befinden sich dann komplett innerhalb des von der umlaufenden Lötverbindung gebildeten Schirms. Ein derartiger Schirm wirkt wie ein faradayscher Käfig. Es können keine von Störströmen hervorgerufenen Magnetfelder eindringen. Ferner können auch keine durch die Signale hervorgerufenen Störungen nach außen gelangen.

Aus konstruktiven Gründen kann auch eine Kombination aus einer punktuellen Schirmanbindung beispielsweise über Stifte, die durch die Leiterplatte gesteckt und mit dem Schirmanschluss verlötet werden, und einer abschnittsweise linearen Verlötung vorteilhaft sein.

Je nach Löttechnologie kann eine Ausgestaltung des Steckverbinders notwendig sein, bei der eine Anbindung der Signalleitungen an die Leiterplatte nur außerhalb der Gehäusekontur möglich ist. Dies ist beispielsweise bei SMD-Bauformen der Fall. Hierbei ist eine Ausführungsform des Steckverbinders vorteilhaft, bei der die Signalanschlüsse über eine der Leiterplatte im montierten Zustand zugewandten Grundfläche des Gehäuses hinausragen und das Gehäuse Seitenwände aufweist, die über die Grundfläche hinweg verlängert sind. Auf diese Art und Weise ist es möglich, eine mit dem Gehäuse verbundene Schirmanbindung bereitzustellen, die wiederum an vier Punkten mit dem Schirmanschluss der Leiterplatte verlötbar ist, wobei die vier Punkte derart angeordnet sind, dass sie zu dem erfindungsgemäß geschlossenen, die Signalanschlusspunkte der Leiterplatte umschließenden Polygonzug verbindbar sind.

Insbesondere beim Einsatz im Industrieumfeld sind eine hohe Störfestigkeit und eine geringe Störaussendung enorm wichtig. Da echtzeitfähige und isochrone Kommunikationssysteme besonders störanfällig sind, ist es hier besonders wichtig, entsprechende Reserven im elektromagnetischen Verhalten vorzuhalten. Daher ist eine Ausgestaltung des Steckverbinders besonders vorteilhaft, bei der der Steckverbinder ein Stecker oder eine Buchse eines industrietauglichen Kommunikationssystems ist.

Da sich die Ethernettechnologie mehr und mehr auch im industriellen Umfeld verbreitet, ist eine weitere Ausgestaltung der Erfindung vorteilhaft, bei der der Steckverbinder als RJ45 Schnittstelle ausgeführt ist.

Im Folgenden wird die Erfindung anhand der in den Figuren dargestellten Ausführungsbeispiele näher beschrieben und erläutert.

Es zeigen:
- FIG 1: einen ersten, auf einer Leiterplatte montierten Steckverbinder gemäß einer Ausführungsform der Erfindung,
- FIG 2: Anschlusspunkte auf der Leiterplatte für den ersten Steckverbinder,
- FIG 3: von über das Schirmsystem fließende Störströme verursachte Magnetfelder bei dem ersten Steckverbinder,
- FIG 4: einen zweiten, auf einer Leiterplatte montierten Steckverbinder gemäß einer Ausführungsform der Erfindung,
- FIG 5: Anschlusspunkte auf der Leiterplatte für den zweiten Steckverbinder,
- FIG 6: einen dritten, auf einer Leiterplatte montierten Steckverbinder gemäß einer Ausführungsform der Erfindung mit verlängerten Seitenwänden und
- FIG 7: von über das Schirmsystem fließende Störströme verursachte Magnetfelder bei dem dritten Steckverbinder.

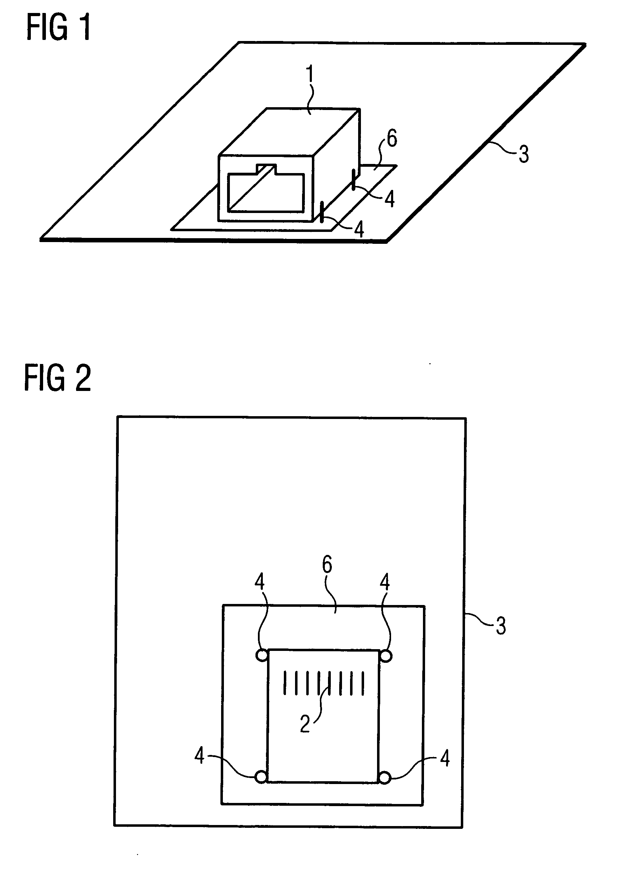

FIG 1 zeigt einen auf einer Leiterplatte 3 montierten Steckverbinder gemäß einer Ausführungsform der Erfindung. Der Steckverbinder umfasst ein Gehäuse 1, welches aus einem elektrisch leitfähigen Metall besteht und daher eine Schirmung des Steckverbinders gegenüber elektromagnetischen Störungen bewirkt. Auf der Leiterplatte 3 befindet sich eine flächige Metallisierung, die die Funktion eines Schirmanschlusses 6 der Leiterplatte hat. Um das elektrisch leitfähige Gehäuse 1 des Steckverbinders mit diesem Schirmanschluss 6 zu verbinden, hat das Gehäuse 1 eine Schirmanbindung 4. Diese Schirmanbindung 4 besteht aus vier elektrisch leitfähigen Stiften, von denen in der Abbildung 1 zwei sichtbar sind. Diese Stifte 4 werden mit dem flächigen Schirmanschluss 6 mit Hilfe einer Lötverbindung niederimpedant elektrisch kontaktiert. Somit können Störströme, die beispielsweise über einen Kabelschirm, der mit dem Steckverbinder verbunden ist, über das Gehäuse 1 des Steckverbinders fließen, zum Schirmanschluss 6 der Leiterplatte 3 und schließlich zu einer zentralen Schirmableitung geführt werden. Der Steckverbinder 1 umfasst ferner Signalanschlüsse, die mit Signalanschlusspunkten 2 auf der der Leiterplatte 3 zugewandten Grundseite des Steckverbinders elektrisch verbunden sind. Die Signalanschlusspunkte 2 befinden sich im montierten Zustand des Steckverbinders innerhalb der Fläche, die durch die vier Stifte 4 begrenzt wird.

Dies ist deutlich in der FIG 2 zu erkennen. FIG 2 zeigt die Anschlusspunkte auf der Leiterplatte für den ersten Steckverbinder. Es ist deutlich zu erkennen, dass die vier Stifte 4 an vier Punkten auf der Leiterplatte 3 mit dem Schirmanschluss 6 verlötet werden, wobei diese vier Eckpunkte zu einem geschlossenen Polygonzug verbindbar sind, und die Signalanschlusspunkte 2 innerhalb der Fläche liegen, die von diesem Polygonzug begrenzt wird. Auf diese Art und Weise werden die Magnetfelder, die von den über das Schirmsystem fließenden Strömen verursacht werden, im Inneren dieses Polygonzug weitgehend kompensiert. Hieraus resultiert eine erhebliche Verbesserung der Störfestigkeit.

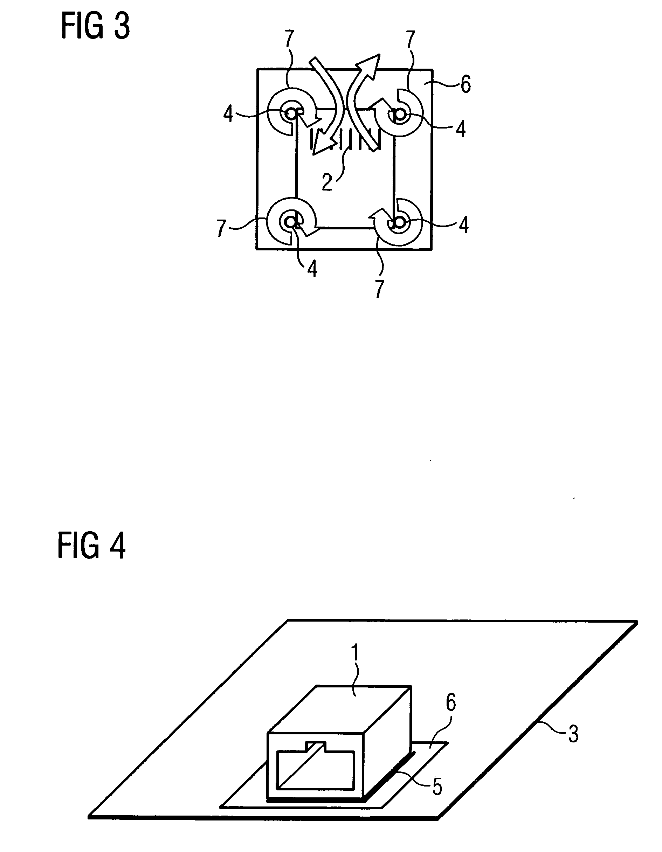

FIG 3 zeigt von über das Schirmsystem fließenden Störströmen verursachte Magnetfelder 7 bei dem ersten Steckverbinder aus FIG 1 und FIG 2. Die kompensierende Wirkung der Einzelmagnetfelder innerhalb des Polygonzuges ist deutlich zu erkennen.

FIG 4 zeigt einen zweiten auf einer Leiterplatte 3 montierten Steckverbinder gemäß einer Ausführungsform der Erfindung. Bei dem dargestellten Steckverbinder handelt es sich um eine Buchse, die wiederum ein elektrisch leitfähiges, schirmendes Gehäuse 1 umfasst. Die Schirmanbindung 5 dieses Steckverbinders ist jedoch im Gegensatz zu der in FIG 1 dargestellten Ausführungsform linear ausgeführt, so dass eine umlaufende Lotkontaktierung entlang der Gehäusekontur mit einem Schirmanschluss 6 der Leiterplatte 3 möglich ist. Auf diese Art und Weise kann eine größtmögliche Schirmung der Schnittstelle zwischen Steckverbinder und Leiterplatte 3 realisiert werden. Eine solche umlaufende Kontaktierung hat den Effekt eines faradayschen Käfigs. Elektromagnetische Störungen können so weder zu den von der umlaufenden Kontaktierung 5 umgebenen Signalanschlusspunkten 2 nach außen gelangen, noch können von außen elektromagnetische Störungen zu den Signalanschlusspunkten 2 eingekoppelt werden.

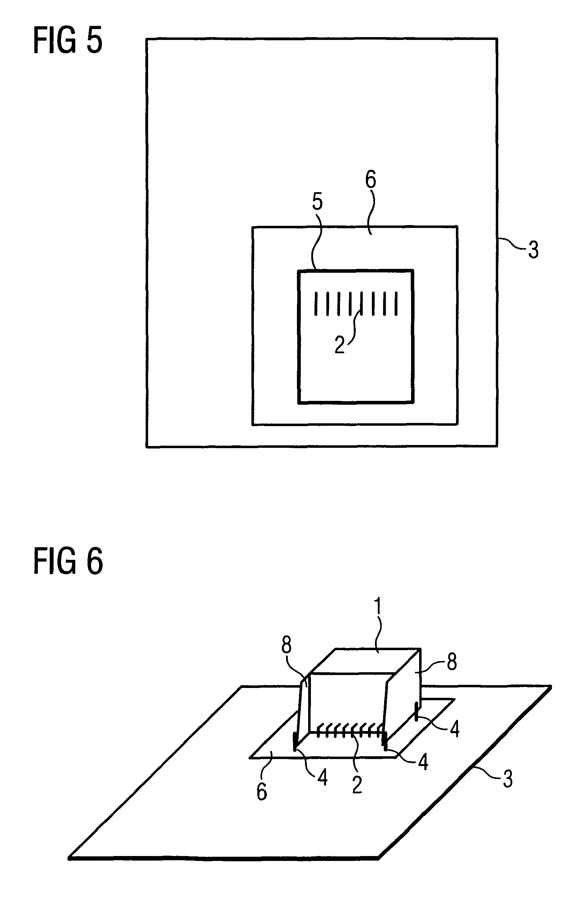

Auch hier zeigt FIG 5 Anschlusspunkte auf der Leiterplatte für den zweiten Steckverbinder. Es ist deutlich zu erkennen, dass auch hier die Signalanschlusspunkte 2 innerhalb einer mittels einer Lötverbindung realisierten elektrischen Kontaktierung liegen, die die Signalanschlusspunkte 2 in Form eines Polygonzuges umschließt. Im Gegensatz zu FIG 1 wird dieser Polygonzug also nicht nur von vier diskreten Punkten gebildet, sondern durch eine unendliche Anzahl von Kontaktierungspunkten, die durch die Gehäusekontur festgelegt sind.

FIG 6 zeigt einen dritten auf einer Leiterplatte 3 montierten Steckverbinder gemäß einer Ausführungsform der Erfindung.

Hierbei handelt es sich um einen Steckverbinder, der mit Hilfe der SMD-Technik auf der Leiterplatte 3 zu montieren ist. Aufgrund dieser Löttechnik ist es nicht möglich, die Signalanschlüsse unterhalb der Grundfläche des Steckverbinders vorzusehen. Unter der Grundfläche wird auch hier die Fläche des Steckverbinders verstanden, die im montierten Zustand der Leiterplatte 3 zugewandt ist. Um trotzdem die vorteilhafte schirmende Wirkung zu erzielen, sind Seitenwände 8 des Gehäuses 1 des Steckverbinders derart über die Grundfläche des Steckverbinders 1 verlängert, dass es trotzdem möglich ist, die Schirmanbindung 4 so zu gestalten, dass sie einen Polygonzug aufspannt, der die Signalanschlusspunkte 2 der Leiterplatte 3 im montierten Zustand des Steckverbinders umschließt.

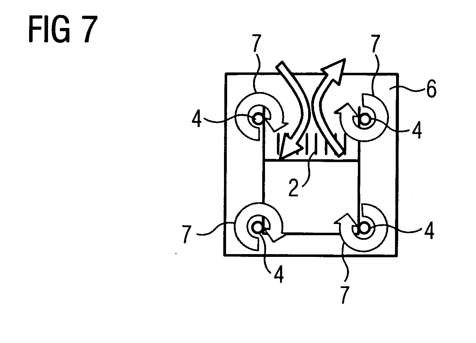

FIG 7 zeigt schließlich von über das Schirmsystem fließenden Störströmen verursachte Magnetfelder bei dem dritten Steckverbinder. Auch hier ist deutlich zu erkennen, dass durch die geschickte Anordnung der Stifte, die die Schirmanbindung 4 des Steckverbindergehäuses 1 darstellen, eine weitgehende Kompensation der Magnetfelder innerhalb des von den Stiften 4 begrenzten Bereiches auf der Leiterplatte 3 ermöglicht wird.

Abschließend sei angemerkt, dass neben den hier dargestellten Ausführungsbeispielen selbstverständlich zahlreiche weitere Realisierungsmöglichkeiten denkbar und von der Erfindung umfasst sind, solange der Grundgedanke, die Signalanschlusspunkte innerhalb einer von der Schirmanbindung begrenzten Fläche anzuordnen, erhalten bleibt. Beispielsweise können auch mehr als vier Stifte verwendet werden, um das Gehäuse 1 des Steckverbinders mit dem Schirmanschluss 6 der Leiterplatte 3 zu verbinden.

## Patentansprüche

1. Steckverbinder zur Montage auf einer Leiterplatte, wobei der Steckverbinder ein schirmendes, elektrisch leitfähiges Gehäuse (1) und Signalanschlüsse zur Verbindung von Signalleitungen mit Signalanschlusspunkten der Leiterplatte (3) umfasst und das Gehäuse (1) eine Schirmanbindung (4,5) zur Verbindung des Gehäuses mit einem Schirmanschluss (6) auf der Leiterplatte aufweist,
**dadurch gekennzeichnet, dass**
die Schirmanbindung (4,5) zur elektrischen Kontaktierung mit dem Schirmanschluss (6) mittels einer Lötverbindung an mindestens vier Punkten ausgebildet ist, die derart angeordnet sind, dass sie zu einem geschlossenen, die Signalanschlusspunkte (2) der Leiterplatte (3) umschließenden Polygonzug verbindbar sind.

2. Steckverbinder nach Anspruch 1,
wobei die Punkte derart angeordnet sind, dass sich magnetische Felder (7), die von einem über die Schirmanbindung (4,5) zum Schirmanschluss (6) fließenden Störstrom ausgehen, innerhalb der vom Polygonzug umschlossenen Fläche weitgehend kompensieren.

3. Steckverbinder nach Anspruch 1 oder 2,
wobei die Schirmanbindung (5) zur elektrischen Kontaktierung mit dem Schirmanschluss (6) mittels einer sich über den Polygonzug zumindest abschnittsweise erstreckenden, linear verlaufenden Lötverbindung ausgebildet ist.

4. Steckverbinder nach einem der vorhergehenden Ansprüche,
wobei die Signalanschlüsse über eine der Leiterplatte im montierten Zustand zugewandten Grundfläche des Gehäuses (1) hinausragen und das Gehäuse (1) Seitenwände (8) aufweist, die über die Grundfläche hinweg verlängert sind.

5. Steckverbinder nach einem der vorhergehenden Ansprüche,
wobei der Steckverbinder ein Stecker oder eine Buchse eines industrietauglichen Kommunikationssystems ist.

6. Steckverbinder nach einem der vorhergehenden Ansprüche,
wobei der Steckverbinder als RJ 45 Schnittstelle ausgeführt ist.
